# EUROPÄISCHE PATENTSCHRIFT

(11) **EP 2 207 042 B1**
(45) Veröffentlichungstag und Bekanntmachung des Hinweises auf die Patenterteilung: **20.11.2013**
(21) Anmeldenummer: 09000259.3
(22) Anmeldetag: 10.01.2009
(51) Int. Cl.: G01R 21/06, G01R 21/133

(54) **Drehstromzähler**
Rotary current meter
Compteur à courant triphasé

(43) Veröffentlichungstag der Anmeldung: 14.07.2010
(73) Patentinhaber: EMH metering GmbH & Co. KG, 19243 Wittenburg (DE)
(72) Erfinder: Hardtstock, Heiko, 21337 Lüneburg (DE)
(74) Vertreter: Graalfs, Edo

(56) Entgegenhaltungen:
- WO-A-01/29572
- WO-A-99/44071
- US-A- 5 289 115
- US-A- 5 764 523
- US-B1- 6 269 316
- US-B1- 6 486 652

## Beschreibung

Die Erfindung bezieht sich auf einen Drehstromzähler nach Patentanspruch 1 bzw. Patentanspruch 2.

Ein elektronischer Drehstromzähler, um den es sich bei der Erfindung handelt, weist pro Phase einen Stromwandler bzw. einen Stromsensor auf, dessen Ausgang mit Hilfe eines Analog-Digitalwandlers digitalisiert wird. In einer Rechenstufe erfolgt die Multiplikation des digitalen Strommesswerts mit einem digitalen Spannungsmesswert der gleichen Phase, Die Multiplikation ergibt bekanntlich die Leistung einer Phase. Für drei Phasen werden die Leistungswerte in einer weiteren Rechenstufe aufsummiert. Wird die Leistung über die Zeit integriert, ergibt sich bekanntlich die verbrauchte Energie, die im Zähler in einem Display angezeigt und in einem Speicher gespeichert wird.

US-Patent Nr. 5,764,523 betrifft einen elektronischen Stromzähler, der Spannungs- und Stromwerte einzelner Phasen über Analog-Digitalwandler in unterschiedlichen Registern speichert, miteinander multipliziert und die phasenbezogenen Leistungen aufsummiert.

Aus US-Patent Nr. 6,269,316 ist ein System und ein Verfahren zur Erkennung von Flicker-Effekten in elektrischen Versorgungsnetzen bekannt. Bei den bekannten Verfahren findet eine Überprüfung statt, ob die an unterschiedlichen Phasen gemessenen Spannungen vorgegebene Toleranzbänder einhalten.

US-Patent Nr. 6,486,652 B1 betrifft einen elektronischen Drehstromzähler, der mit Sensoren für Spannung und Strom, nachfolgender Analog-Digitalwandlung und mit einem Mikrocomputer eine Leistungsmcssung durchführt.

Der Erfindung liegt die Aufgabe zugrunde, einen Drehstromzähler der eingangs genannten Art ohne größeren Aufwand wahlweise auch als Einphasenwechselstrom-zähler einsetzen zu können.

Diese Aufgabe wird durch die Merkmale der Ansprüche 1 oder 2 gelöst.

Bei dem Drehstromzähler nach Anspruch 1 ist ein Detektor vorgesehen, der feststellt, ob zwei Phasen eine Spannung führen, die kleiner ist als ein vorgegebener Spannungsmindestwert. Dies ist der Fall, wenn die Verbindung von zwei Phasen eines Drehstromnetzes zum Zähler unterbrochen ist. Dann werden mit den Stromsensoren dieser Phasen keine oder nur sehr geringe Ströme gemessen und die Spannung ist im Wesentlichen Null. Gemessene Ströme sind dann allenfalls durch Induktion (z.B. durch externe Magnetfelder) erzeugt. Bei der Erfindung ist ferner eine Korrekturstufe vorgesehen, die mit den Messströmen der an Spannung liegenden einen Phase und einer weiteren abgeschalteten Phase beaufschlagt ist, wenn der vorgegebene Spannungswert dieser Phase am Detektor unterschritten wird. Mit der Korrekturstufe wird der Messstrom der an Spannung liegenden Phase durch einen weiteren Messstrom, der als Fehlstrom auch an der benachbarten Phase erscheint, korrigiert.

Die Erfindung geht von der Erkenntnis aus, dass ein Messstrom, der in der an Spannung liegenden Phase fließt, durch Induktion am Messwandler verfälscht ist. Diese Verfälschung tritt in dem gleichen Maße auch in einer nicht an Spannung liegenden Phase auf: Werden daher die Messströme beider Phasen subtrahiert, ergibt sich der richtige Strommesswert der an Spannung liegenden Phase.

Eine alternative Lösung der gestellten Aufgabe stellt Anspruch 2 dar. Der Drehstromzähler ist in gleicher Weise aufgebaut, wie dies zu Anspruch 1 erläutert ist. Erfindungsgemäß sind der Leistungsausgang der an Spannung liegenden Phase und ein vom Strom einer weiteren Phase und der Spannung der an Spannung liegenden Phase gebildeten Leistungsausgang mit einer Korrekturstufe verbunden. Auch hier wird die Fehlleistung, die in der an Spannung liegenden Phase erscheint, in gleichem Maße auch an einer nicht an Spannung liegenden Phase gebildet, so dass eine Subtraktion beider Leistungswerte den tatsächlichen Leistungswert erbringt.

Mit Hilfe der beschriebenen Maßnahmen lässt sich ein Drehstromzähler problemlos zu einem präzise messenden Wechselstromzähler wandeln, indem zwei Phasen vom Drehstromnetz getrennt werden. Es versteht sich, dass die erfindungsgemäßen Vorkehrungen im Wesentlichen für Elektrizitätszähler sinnvoll anwendbar sind, die magnetisch beeinflussbare Stromsensoren aufweisen.

Nach einer Ausgestaltung der Erfindung ist vorgesehen, dass der Detektor mit einem Umschalter verbunden ist, der wahlweise den Strommessausgang der an Spannung liegenden Phase oder den Ausgang der Korrekturstufe mit der Leistungsmessstufe des Rechners verbindet. Bei einer Leistungskorrektur hingegen verbindet der Umschalter den Schaltkontakt wahlweise mit dem Leistungsausgang der Leistungsstufe des Rechners oder dem Ausgang der Leistungskorrekturstufe.

Der Detektor ist vorzugsweise als Schwellwertstufe ausgebildet, in der festgestellt wird, ob eine gemessene Spannung einen vorgegebenen Wert unterschreitet.

Zwei Ausführungsbeispiele der Erfindung werden nachfolgend anhand von Zeichnungen näher erläutert.
- Fig. 1: zeigt schematisch einen Teil eines Drehstromwandlers, der für den Einsatz als Einphasenwechselstromzähler geeignet ist.
- Fig. 2: zeigt ein Schaltbild einer zweiten Ausführungsform eines Drehstromzählers, der zum Einsatz als Einphasenwechselstromzähler geeignet ist.

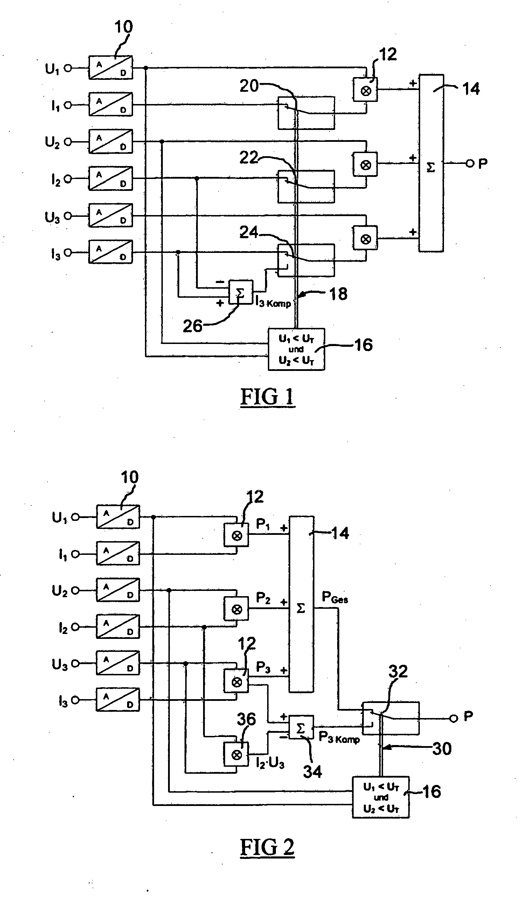

In Fig. 1 wird das Prinzip für die Benutzung der Phase L3 für Wechselstrombetrieb dargestellt. Es liegen an drei Phasen eines Drehstromzählers die Spannungen U₁ bis U₃ an bzw. fließen die Ströme I₁ bis I₃. Die Ströme I₁ bis I₃ kommen von nicht gezeigten Stromsensoren, beispielsweise Messwandlern, die von den Netzströmen durchflossen sind. Die Spannungen werden unmittelbar oder über einen Spannungsteiler von den Netzanschlüssen abgeleitet. Die Spannungs- und Strommesswerte werden jeweils in einem Analog-Digitalwandler 10 in digitale Werte umgewandelt. Die Strom- und Spannungsmesswerte einer Phase gelangen jeweils auf eine Multiplikationsstufe 12 eines Rechners, und die auf diese Weise gebildeten Leistungswerte gelangen auf eine Summierstufe 14. Die summierten Werte P werden zur Ermittlung der verbrauchten Energie in weiteren Stufen des Rechners bearbeitet zwecks Anzeige und Speicherung. Ein Detektor 16 ist mit Spannungsausgängen der Analog-Digitalwandler 10 verbunden. Mit Hilfe des Detektors 16 wird festgestellt, ob die gemessene Spannung kleiner ist als eine vorgegebene Schwellspannung U_{T}. Ist dies der Fall, wird ein Schalter betätigt, der generell mit 18 bezeichnet ist. Erste Kontakte 20 bzw. 22 trennen den Analog-Digitalwandler 10 für die Stromeingänge I₁ und I₂ von Multiplikationsstufe 12. Ein weiterer Schaltkontakt 24 unterbricht die Verbindung des Analog-Digitalwandlers 10 für den Strom I₃ der dritten Phase zur zugehörigen Multiplikationsstufe und wird stattdessen auf den Ausgang einer Korrekturstufe 26 gelegt. Der Eingang der Korrekturstufe 26 wird mit dem Ausgang des A/D-Wandlers für den Stromeingang I₂ sowie mit dem Stromausgang I₃ der dritten Phase verbunden. In der Korrekturstufe 26 wird der Strom I₂ vom Strom I₃ subtrahiert, und am Ausgang erscheint ein korrigierter Strommesswert I_{3 Komp}. Auch bei abgeschalteten Phasen 1 und 2 fließt am Ausgang des zugehörigen A/D-Wandlers ein geringer Strom, der in gleichem Maße auch Bestandteil des Strom I₃ ist und durch magnetische Beein-flussung induziert wird. Falls eine Korrektur des gemessenen Stromwertes nicht stattfindet, wird für die Zählung ein fehlerhafter Strommesswert herangezogen. Durch die gezeigte Maßnahme erfolgt jedoch eine Korrektur, so dass der Drehstromzähler problemlos als Einphasenwechselstromzähler eingesetzt werden kann.

Soweit in dem Ausführungsbeispiel nach Fig. 2 gleiche Teile wie in Fig. 1 verwendet werden, werden auch gleiche Bezugszeichen gewählt. Fig. 2 zeigt das Prinzip auch für die Benutzung der Phase L3 für Wechselstrombetrieb.

In Fig. 2 betätigt der Detektor 16 einen Schalter 30. Sein Schaltkontakt 32 ist wahlweise mit dem Ausgang einer Korrekturstufe 34 verbunden oder mit dem Ausgang der Summierstufe 14 für die gemessene Leistung des Drehstromzählers. Die Korrekturstufe 34 ist mit dem Ausgang der Multiplikationsstufe 12 für die Phase 3 verbunden und mit dem Ausgang einer weiteren Multiplikationsstufe 36, die mit dem Strommesswert der Phase 2 und dem Spannungsmesswert der Phase 3 beaufschlagt ist.

Bei nicht am Netz liegenden Phasen 1 und 2 wird dies vom Detektor 16 ermittelt, und dieser schaltet den Schaltkontakt 32 auf den Ausgang der Korrekturstufe 34. In der Korrekturstufe erfolgt eine Subtraktion des in der Multiplikationsstufe 36 ermittelten Leistungswertes I₂ x U₃, der eine Fehlleistung repräsentiert, von dem Ausgang der Multiplikationsstufe 12, der den zu korrigierenden Leistungsmesswert I₃ x U₃ darstellt. Auf diese Weise wird die gemessene Leistung um einen durch magnetische Beeinflussung entstehenden Fehlwert korrigiert.

## Patentansprüche

1. Drehstromzähler mit einer Leistungsmessstufe eines Rechners, die dazu ausgebildet ist, für drei Phasen pro Phase die von jeweils einem Analog-Digitalwandler kommenden Messwerte für Strom und Spannung zur Ermittlung der phasenbezogenen Leistungen zu multiplizieren und die phasenbezogenen Leistungen aufzusummieren, wobei für eine Verwendung des Drehstromzählers als Einphasenwechsetstromzähler ein Detektor (16) vorgesehen ist, der dazu ausgebildet ist, festzustellen, ob zwei der Phasen eine Spannung haben, die kleiner ist als ein vorgegebener Spannungsmindestwert, also nicht an Spannung liegen, und in diesem Fall einen Schalter (18) zu betätigen, der dazu ausgebildet ist, die Verbindung einer Korrekturstufe (26) mit den Messströmen der an Spannung liegenden Phase und einer der nicht an Spannung liegenden Phasen zu veranlassen, wobei die Korrekturstufe (26) dazu ausgebildet ist, den Messstrom der an Spannung liegenden Phase durch den Messstrom der einen nicht an Spannung liegenden Phase zu korrigieren.

2. Drehstromzähler mit einer Leistungsmessstufe eines Rechners, die dazu ausgebildet ist, für drei Phasen, die jeweils einen Leistungsausgang aufweisen, pro Phase die von jeweils einem Analog-Digitalwandler kommenden Messwerte für Strom und Spannung zur Ermittlung der phasenbezogenen Leistungen zu multiplizieren und die phasenbezogenen Leistungen aufzusummieren, wobei für eine Verwendung des Drehstromzählers als Einphasenwechselstromzähler ein Detektor (16) vorgesehen ist, der dazu ausgebildet ist, festzustellen, ob zwei Phasen eine Spannung haben, die kleiner ist als ein vorgegebener Spannungsmindestwert, also nicht an Spannung liegen, und in diesem Fall einen Schalter (30) zu betätigen, der dazu ausgebildet ist, die Verbindung einer Korrekturstufe (34) mit dem Leistungsausgang der an Spannung liegenden Phase und einem weiteren Leistungsausgang zu veranlassen, der vom Strom einer der nicht an Spannung liegenden Phasen und der Spannung der an Spannung liegenden Phase gebildet ist, wobei die Korrekturstufe (34) dazu ausgebildet ist, die gemessene Leistung der an Spannung liegenden Phase durch den weiteren Leistungsausgang zu korrigieren.

3. Drehstromzähler nach Anspruch 1, dadurch gekenntzeichnet, dass der Detektor (16) mit einem Umschalter (24) verbunden ist, der dazu ausgebildet ist, wahlweise den Strommessausgang der an Spannung liegenden Phase mit dem Ausgang der Korrekturstufe (26) zu verbinden.

4. Drehstromzähler nach Anspruch 2, **dadurch gekennzeichnet, dass** die Leistungsmessstufe des Rechners einen Leistungsausgang aufweist und der Detektor (16) mit einem Umschalter (32) verbunden ist, dessen Schaltkontakt wahlweise mit dem Leistungsausgang der Leistungsmessstufe des Rechners oder mit dem Ausgang der Korrekturstufe (34) verbunden ist.

5. Drehstromzähler nach einem der Ansprüche 1 bis 4, **dadurch gekennzeichnet dass** die Funktionalität durch Software umgesetzt wird.

## Claims

1. A rotary current meter with a power measurement stage of a computer, the measurement stage being adapted to multiply measurement values for current and voltage per phase for three phases, each measurement value coming from an analog-digital converter, in order to determine the phase-related powers and to sum up the phase-related powers, wherein a detector (16) is provided for using the rotary current meter as a one-phase alternating current meter, the detector (16) being adapted to determine whether two of the phases have a voltage which is smaller than a given voltage minimum value, hence are not under voltage, and in this case to actuate a switch (18) which is adapted to cause the connection of a correction stage (26) to the measurement currents of the phase under voltage and of one of the phases not under voltage, wherein the correction stage (26) is adapted to correct the measurement current of the phase under voltage by the measurement current of the one phase not under voltage.

2. A rotary current meter with a power measurement stage of a computer, the measurement stage being adapted to multiply measurement values for current and voltage per phase for three phases each comprising a power output, each measurement value coming from an analog-digital converter, in order to determine the phase-related powers and to sum up the phase-related powers, wherein a detector (16) is provided for using the rotary current meter as a one-phase alternating current meter, the detector (16) being adapted to determine whether two of the phases have a voltage which is smaller than a given voltage minimum value, hence are not under voltage, and in this case to actuate a switch (30) which is adapted to cause the connection of a correction stage (34) to the power output of the phase under voltage and a further power output which is formed by the current of one of the phases not under voltage and the voltage of the phase under voltage, wherein the correction stage (34) is adapted to correct the measured power of the phase under voltage through the further power output.

3. The rotary current meter according to claim 1, **characterised in that** the detector (16) is connected to a change-over switch (24), which is adapted to connect the current measurement output of the phase under voltage to the output of the correction stage (26) at option.

4. The rotary current meter according to claim 2, **characterised in that** the power measurement stage of the computer comprises a power output and the detector (16) is connected to a change-over switch (32), whose make-and-break contact is connected to the power output of the power measurement stage of the computer, or to the output of the correction stage (34) at option.

5. A rotary current meter according to any one of claims 1 to 4, **characterised in that** the functionality is implemented by software.

## Revendications

1. Compteur à courant triphasé avec un étage de mesure de puissance d'un ordinateur, l'étage de mesure étant adapté à multiplier des valeurs de mesure pour courant et tension par phase par phase, chacune valeur de mesure provenant d'un convertisseur analogique/numérique, afin de déterminer les puissances relatifs aux phases et de totaliser les puissances relatifs aux phases, dans lequel un capteur (16) est prévu pour utiliser le compteur à courant triphasé comme un compteur à courant alternatif monophasé, le capteur (16) étant adapté à déterminer si deux des phases ont une tension qui est moins qu'une valeur minimale de tension donnée, donc ne sont pas sous tension, et dans ce cas à actionner un commutateur (18) qui est adapté à ordonner la connexion d'un étage de correction (26) aux courants de mesure de la phase sous tension et une des phases ne pas sous tension, l'étage de correction (26) étant adapté à corriger le courant de mesure de la phase sous tension par le courant de mesure de l'une phase ne pas sous tension.

2. Compteur à courant triphasé avec un étage de mesure de puissance d'un ordinateur, l'étage de mesure étant adapté à multiplier des valeurs de mesure pour courant et tension par phase par phase, chacune valeur de mesure provenant d'un convertisseur analogique/numérique, afin de déterminer les puissances relatifs aux phases et de totaliser les puissances relatifs aux phases, dans lequel un capteur (16) est prévu pour utiliser le compteur à courant triphasé comme un compteur à courant alternatif monophasé, le capteur (16) étant adapté à déterminer si deux des phases ont une tension qui est moins qu'une valeur minimale de tension donnée, donc ne sont pas sous tension, et dans ce cas à actionner un commutateur (30) qui est adapté à ordonner la connexion d'un étage de correction (34) à la puissance délivrée en sortie de la phase sous tension et à une autre puissance délivrée en sortie qui est formée par le courant d'une des phases ne pas sous tension et la tension de la phase sous tension, l'étage de correction (34) étant adapte à corriger la puissance mesurée de la phase sous tension par l'autre puissance délivrée en sortie.

3. Compteur à courant triphasé selon la revendication 1, **caractérisé en ce que** le capteur (16) est relié à un commutateur inverseur (24), qui est adapté à relier la sortie de mesure de courant de la phase sous tension à la sortie de l'étage de correction (26) au choix.

4. Compteur à courant triphasé selon la revendication 2, **caractérisé en ce que** l'étage de mesure de puissance de l'ordinateur comporte une sortie de puissance, et que le capteur (16) est relié à un commutateur inverseur (32), dont le contact à fermeture est relié à la sortie de puissance de l'étage de mesure de puissance de l'ordinateur ou à la sortie de l'etage de correction (34) au choix.

5. Compteur à courant triphasé selon l'une quelconque des revendications 1 à 4, **caractérisé en ce que** la fonctionnalité est réalisée par logiciel.
